(19) Europäisches Patentamt
European Patent Office
Office européen des brevets

(11) **EP 2 082 331 B1**

(12) **EUROPÄISCHE PATENTSCHRIFT**

(45) Veröffentlichungstag und Bekanntmachung des Hinweises auf die Patenterteilung:
**31.08.2011 Patentblatt 2011/35**

(51) Int Cl.:
***G06F 17/10*** *(2006.01)*     ***G09G 5/39*** *(2006.01)*
***G11C 16/10*** *(2006.01)*

(21) Anmeldenummer: **07818476.9**

(22) Anmeldetag: **26.09.2007**

(86) Internationale Anmeldenummer:
**PCT/EP2007/008393**

(87) Internationale Veröffentlichungsnummer:
**WO 2008/049497 (02.05.2008 Gazette 2008/18)**

(54) **VERFAHREN UND VORRICHTUNG ZUR INKREMENTIERUNG VON IN SPEICHERZELLEN EINES SPEICHERS GESPEICHERTEN ZÄHLERSTÄNDEN**

METHOD AND DEVICE FOR INCREMENTING THE COUNTER READINGS STORED IN THE MEMORY CELLS OF A MEMORY

PROCÉDÉ ET DISPOSITIF POUR INCRÉMENTER DES POSITIONS DE COMPTEUR MÉMORISÉES DANS DES CELLULES DE MÉMOIRE D'UNE MÉMOIRE

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **26.10.2006 DE 102006050617**
**03.01.2007 DE 102007001043**

(43) Veröffentlichungstag der Anmeldung:
**29.07.2009 Patentblatt 2009/31**

(73) Patentinhaber: **Rohde & Schwarz GmbH & Co. KG**
**81671 München (DE)**

(72) Erfinder: **SCHMIDT, Kurt**
**85567 Grafing (DE)**

(74) Vertreter: **Körfer, Thomas**
**Mitscherlich & Partner**
**Patent- und Rechtsanwälte**
**Postfach 33 06 09**
**80066 München (DE)**

(56) Entgegenhaltungen:
**US-A- 5 757 364      US-A- 5 818 434**
**US-A1- 2005 222 788      US-A1- 2006 209 081**

EP 2 082 331 B1

**Beschreibung**

Die Erfindung betrifft ein Verfahren und eine Vorrichtung zur Inkrementierung von in Speicherzellen eines Speichers gespeicherten Zählerständen.

Zum gegenwärtigen Stand der Organisation von Bildschirm Speichern wird z. B. auf die US 2006/0209081 A1 verwiesen.

In der US 5,818,434 A sind ein Verfahren und eine Vorrichtung zur Steuerung der Bilddarstellung für einen Monitor offenbart. Hierzu werden die Bilddaten auf Pixelebene in einem ersten Speicher abgespeichert. In einem zweiten Speicher, dessen Speicherzellenanzahl der Anzahl von Bildpunkten auf dem Monitor entspricht, ist in jeder einzelnen Speicherzelle jeweils die Adresse des Bildpunktes im ersten Speicher abgelegt, der auf dem zur Adresse des zweiten Speichers gehörigen Bildpunkt des Monitors dargestellt wird.

Messgeräte und -systeme bieten heutzutage die Darstellung von Pegelwert-Verteilungen eines zu messenden Signals über der Frequenz oder über der Zeit an. Hierzu wird in einem bestimmten Zeitraster ermittelt, ob jeweils ein Pegelwert des zu messenden Signals im jeweiligen Pegelbereich und zum jeweiligen Wert des Frequenz- oder Zeitraster vorliegt. Bei Vorliegen eines Pegelwertes des Messsignals wird ein zum jeweiligen Pegelbereich und zum jeweiligen Wert des Frequenz- oder Zeitraster gehörige Zähler inkrementiert. Am Ende der Messzeit werden die Zählerstände aller Zähler ausgelesen und der Anzeige-Einrichtung zur Aktualisierung der Darstellung zugeführt.

Die Zählerstände der zu den einzelnen Pegelbereichen und zu den einzelnen Werten des Frequenz- oder Zeitraster jeweils gehörigen Zähler werden in den Speicherzellen eines der Anzeige-Einrichtung vorgeschalteten Speichers abgelegt. Typischerweise werden mehrere benachbarte Speicherzellen in einer Zeile oder in einer Spalte des Speichers gleichzeitig inkrementiert (beispielsweise bei konstanten Signalpegel über weiten Frequenz- oder Zeitbereich oder bei gleich hoher Häufigkeit in benachbarten Signalpegelbereichen eines Frequenz- oder Zeitwerts).

Im ungünstigsten Fall müssen alle Speicherzellen einer Zeile oder einer Spalte des Speichers in jedem Messzyklus inkrementiert werden, was zu einer extrem hohen Zugriffsrate auf den Speicher führt, die deutlich höher als die Abtastrate des abgetasteten Messsignals ist. Eine derartige Inkrementierung von Speicherzellen eines Speichers in Echtzeit ist bei einer heute verfügbaren Auflösung der Anzeigeeinrichtung - typischerweise 1000•600 Bildpunkte - und bei einer hohen Abtastrate des abgetasteten Messsignals - beispielsweise einige 100 MHz - zum heutigen Zeitpunkt noch nicht realisierbar.

Aufgabe der Erfindung ist es deshalb, ein Verfahren und eine Vorrichtung zur effizienten Inkrementierung von Zählerständen in Echtzeit zu schaffen, die jeweils in einer Speicherzelle eines der Anzeige-Einrichtung vorgelagerten Speichers abgelegt sind.

Die Erfindungsaufgabe wird durch ein Verfahren zur Inkrementierung von in Speicherzellen eines Speichers gespeicherten Zählerständen mit den Merkmalen des Anspruchs 1 und durch eine Vorrichtung zur Inkrementierung von in Speicherzellen eines Speichers gespeicherten Zählerständen mit den Merkmalen des Anspruchs 6 gelöst.

Sind in einem Messzyklus jeweils mehrere Zählerstände von Speicherzellen zu inkrementieren, die jeweils in Zeilen oder Spalten eines der Anzeige-Einrichtung vorgelagerten ersten Speichers benachbart angeordnet sind, so werden erfindungsgemäß in einem dem ersten Speicher vorgelagerten zweiten Speicher jeweils nur diejenigen Speicherzellen gekennzeichnet, die denjenigen Speicherzellen des ersten Speichers entsprechen, welche am Beginn und am Ende der Folge von benachbarten und zu inkrementierenden Speicherzellen positioniert sind. Hierbei wird zum Speicherinhalt der Speicherzelle des zweitens Speichers, die zur Speicherzelle des ersten Speichers am Beginn der Folge von zu inkrementierenden Speicherzellen korrespondiert, eine Konstante m, z. B. "1", und zum Speicherinhalt der Speicherzelle des zweiten Speichers, die zu der am Ende der Folge von zu inkrementierenden Speicherzellen folgenden Speicherzelle des ersten Speichers korrespondiert, die negierte Konstante -m, z. B. "-1", hinzuaddiert.

Nach einer gewissen Anzahl von Messzyklen - typischerweise bis $2^{18}$ - wird erfindungsgemäß für alle Speicherzellen des ersten Speichers jeweils der Speicherinhalt der zur Speicherzelle des ersten Speichers korrespondierenden Speicherzelle des zweiten Speichers zum Speicherinhalt derjenigen Speicherzelle des ersten Speichers addiert, die jeweils in der nächst niedrigeren Zeile oder Spalte des ersten Speichers positioniert ist, und nach der Addition jeweils in der Speicherzelle des ersten Speichers abgespeichert. Anschließend werden die Speicherzellen des zweiten Speichers zurückgesetzt.

Bei einer Folge von in einer Zeile oder Spalte des ersten Speichers benachbarten und zu inkrementierenden Speicherzellen reduziert sich die Anzahl der Inkrementierungen auf eine einzige Inkrementierung - Addition von m bzw. "1" - der zur Speicherzelle am Beginn der Folge der zu inkrementierenden Speicherzellen des ersten Speichers korrespondierenden Speicherzelle des zweiten Speichers und eine einzige Dekrementierung - Addition von -m bzw. "-1" - der zu der auf die Speicherzelle am Ende der Folge der zu inkrementierenden Speicherzellen des ersten Speichers folgenden Speicherzelle korrespondierenden Speicherzelle des zweiten Speichers. Sind in mehreren Messzyklen die Zählerstände in einer Folge von benachbarten Speicherzellen des ersten Speichers zu inkrementieren, so ist jedes Mal nur eine einzige Inkrementierung und eine einzige Dekrementierung durchzuführen.

Damit die Zeitverzögerung, die durch die rekursive Addition der Aktualisierung aller Speicherzellen des ersten Speichers und durch die Rücksetzung aller Speicherzellen des zweiten Speichers hervorgerufen wird, die erneute Inkrementierung bzw. Dekrementierung der Speicherzellen des zweiten Speichers infolge des kontinuierlich abgetasteten Messsignals nicht behindert, wird dem zweiten Speicher in einer ersten Ausführungsform der erfindungsgemäßen Vorrichtung ein first-in-first-out-Speicher vorgeschaltet, der die Informationen zur Inkrementierung der einzelnen Speicherzellen des ersten Speichers zwischenspeichert, bis die rekursive Addition der Aktualisierung aller Speicherzellen des ersten Speichers und die Rücksetzung aller Speicherzellen des zweiten Speichers abgeschlossen ist. In einer zweiten Ausführungsform der erfindungsgemäßen Vorrichtung ist ein dritter. Speicher vorgesehen, der zum zweiten Speicher parallel geschaltet und im zyklischen Wechsel mit dem zweiten Speicher die innerhalb eines Messzykluses in den einzelnen Speicherzellen des ersten Speichers durchzuführende Anzahl von Inkrementierungen enthält.

Im folgenden wird ein Ausführungsbeispiel des erfindungsgemäßen Verfahrens und der erfindungsgemäßen Vorrichtung zur Inkrementierung von in Speicherzellen eines Speichers gespeicherten Zählerständen anhand der Zeichnung im Detail erläutert. Die Figuren der Zeichnung zeigen:

Fig.1   eine Darstellung des prinzipiellen Erfindungsgedankens des erfindungsgemäßen Verfahrens und der erfindungsgemäßen Vorrichtung zur Inkrementierung von in Speicherzellen eines Speichers gespeicherten Zählerständen;

Fig. 2   ein Flussdiagramm des erfindungsgemäßen Ver- fahrens zur Inkrementierung von in Speicher- zellen eines Speichers gespeicherten Zähler- ständen;

Fig. 3A   ein Blockdiagramm einer ersten Ausführungsform der erfindungsgemäßen Vor- richtung zur Inkrementierung von in Speicherzellen eines Speichers gespeicherten Zählerständen;

Fig. 3B   ein Blockdiagramm einer zweiten Ausführungsform der erfindungsgemäßen Vor- richtung zur Inkrementierung von in Speicherzellen eines Speichers gespeicherten Zählerständen und

Fig. 4   eine beispielhafte Speicherbelegung des ersten und zweiten Speichers der erfindungsgemäßen Vorrichtung zur Inkrementierung von in Speicherzellen eines der Speicher gespeicherten Zählerständen.

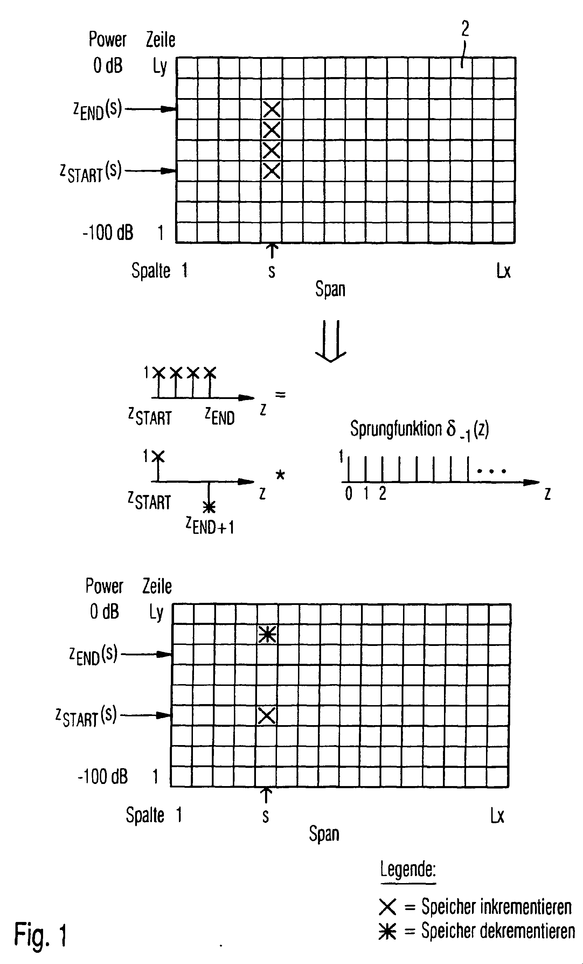

Im folgenden werden anhand von Fig. 1 die mathematischen Grundlagen hergeleitet, die für das Verständnis des erfindungsgemäßen Verfahrens und der erfindungsgemäßen Vorrichtung zur Inkrementierung von in Speicherzellen eines Speichers gespeicherten Zählerständen erforderlich sind.

Wie im oberen Teilbild der Fig. 1 dargestellt ist, wird im folgenden beispielhaft von einer Inkrementierung der Zählerstände in einer Folge von Speicherzellen ausgegangen, die in einer Spalte s des ersten Speichers 1 angeordnet sind. Hierzu werden die zur Folge von Speicherzellen der Spalte s des ersten Speichers 1 korrespondierenden Speicherzellen des zweiten Speichers 2 beispielsweise durch Abspeicherung einer "1" gekennzeichnet. Anstatt einer "1" kann jedoch jede beliebige Konstante +m verwendet werden. Die Inkrementierung einer in einer Zeile des ersten und zweiten Speichers 1 und 2 angeordneten Folge von Speicherzellen wird analog behandelt und ist ebenfalls von der Erfindung abgedeckt. Die Inkrementierung der Zählerstände in einer Folge von in einer Zeile z des ersten Speichers angeordneten Speicherzellen erfolgt in analoger Weise.

Die zwischen der unteren Zeile $z_{start}$ und der oberen Zeile $z_{end}$ in der Spalte s befindliche Folge rec(z) von Speicherzellen des ersten Speichers 1, die in einem Mess-Zyklus gleichzeitig inkrementiert werden, und deren korrespondierende Speicherzellen des zweiten Speichers 2 jeweils z. B. mit dem Wert "1" gekennzeichnet sind, kann mathematisch als Faltungsergebnis eines Dirac-Impulses $\delta_0(z)$ in der Zeile $z_{start}$ mit dem Wert "1" und eines Dirac-Impulses $\delta_0(z)$ in der Zeile $z_{end}$ +1 mit dem Wert "-1" (allgemein mit der Konstante -m) mit einer eine Sprungfunktion $\delta_{-1}(z)$ darstellende Folge von "1"-Werten entsprechend Gleichung (1) gedeutet werden.

$$rec(z) = \left[\delta_0(z - z_{start}) - \delta_0(z - z_{end} - 1)\right] * \delta_{-1}(z) \qquad (1)$$

Auf diese Weise reduziert sich die Kennzeichnung im zweiten Speicher 2 auf die Belegung der Speicherzelle in der Zeile $z_{start}$ und in der Spalte s mit dem Wert "1" (allgemein +m) und der Speicherzelle in der Zeile $z_{end}$ +1 und in der Spalte s mit dem Wert "-1" (allgemein -m) anstelle der Belegung der Speicherzellen zwischen den Zeilen $z_{start}$ und $z_{end}$ in der Spalte s mit dem Wert "1" .

Die Faltung gemäß Gleichung (1) kann alternativ als Summation gemäß Gleichung (2) über die in den Speicherzellen der Spalte s abgespeicherten Speicherinhalte beginnend mit der Zeile 1 durchgeführt werden:

$$rec(z) = \sum_{\alpha=1}^{z} \left[ \delta_0(\alpha - z_{start}) - \delta_0(\alpha - z_{end} - 1) \right] \qquad (2)$$

In jedem Mess-Zyklus $\beta$ wird gemäß Gleichung (3) die Speicherzelle in der Spalte s und in der Zeile $z_{start}$ ($\beta$), die den Beginn der Folge von zu inkrementierenden Speicherzellen des ersten Speichers 1 darstellt, mit dem Wert +m bzw. "1" und die Speicherzelle in der Spalte s und in der auf die Zeile $z_{end}$ ($\beta$) , die das Ende der Folge von zu inkrementierenden Speicherzellen des ersten Speichers 1 darstellt, folgenden Zeile $z_{end}$ ($\beta$)+1 mit dem Wert -m bzw. "-1" belegt. Nach insgesamt $\nu$ Mess-Zyklen ergibt sich die Anzahl $m\_NofTreffer(s,z)$ durchzuführender Inkrementierungen in der Speicherzelle der Zeile z und der Spalte s des ersten Speichers 1 für alle $Lx$ Spalten des ersten und zweiten Speichers gemäß Gleichung (3):

$$m\_NofTreffer(s,z) = \sum_{\beta=1}^{\nu} \sum_{\alpha=1}^{z} \left[ \delta_0(\alpha - z_{start}(\beta)) - \delta_0(\alpha - z_{end}(\beta) - 1) \right]$$
$$\text{für alle } 1 \leq s \leq Lx \quad (3)$$

Da die zweidimensionale Summation in Gleichung (3) zur Ermittlung der Anzahl $m\_NofTreffer(s,z)$ durchzuführender Inkrementierungen in der Speicherzelle der Zeile z und der Spalte s des ersten Speichers 1 vergleichsweise aufwändig ist, wird erfindungsgemäß ausgenutzt, dass die Dirac-Funktionen $\delta_0(\alpha\text{-}z_{start}$ ($\beta$)) und $\delta_0(\alpha\text{-}z_{end}$ ($\beta$)-1) in Gleichung (3) einzig von Null verschiedene Werte aufweisen, wenn die Laufvariable $\alpha$ jeweils die Werte $z_{start}$ ($\beta$) bzw. $z_{end}$ ($\beta$)+1 aufweist. Insofern ist für jede Spalte s des ersten Speichers einzig die Speicherzellen mit einem von Null verschiedenen Wert der Dirac-Funktionen $\delta_0(\alpha\text{-}z_{start}$ ($\beta$)) und $\delta_0(\alpha\text{-}z_{end}$ ($\beta$)-1) erfindungsgemäß zu ermitteln und zu kennzeichnen.
Da eine derartige Kennzeichnung nicht nur für die gekennzeichnete Speicherzelle, sondern entsprechend Gleichung (3) für alle Speicherzellen in einer entsprechend höheren Zeile derselben Spalte s des ersten Speichers 1 gilt, kann erfindungsgemäß nach Abspeicherung der Kennzeichnung in der gekennzeichneten Speicherzelle der Spalte s auf eine erneute Ermittlung der Kennzeichnung für alle in höheren Zeilen derselben Spalte des ersten Speichers 1 positionierten Speicherzellen verzichtet werden. Die Funktion der Gleichung (3) lässt sich also erfindungsgemäß, wie im folgenden gezeigt wird, in die beiden in Gleichung (4) und (5) dargestellten Funktionen zerlegen.
Erfindungsgemäß wird in den einzelnen Mess-Zyklen jeweils in derjenigen Speicherzelle der Spalte s des ersten Speichers 1 der Wert "1" dazuaddiert, wenn die auftretende Dirac-Funktion $\delta_0(\alpha\text{-}z_{start}$ ($\beta$)) beim zur Speicherzelle gehörigen Laufindex $\alpha$ den Wert "1" aufweist, und in der Speicherzelle der Spalte s des ersten Speichers 1 der Wert "-1" dazuaddiert, wenn bei die auftretende Dirac-Funktion $\delta_0(\alpha\text{-}z_{end}$ ($\beta$)-1) beim zur Speicherzelle gehörigen Laufindex $\alpha$ den Wert "1" aufweist.
Gemäß Gleichung (4) wird folglich im jeweiligen Mess-Zyklus $\beta$ der Speicherinhalt $m\_temp(s,z)$ der Speicherzelle in der Spalte s und in der Zeile $z_{start}$ ($\beta$) des zweiten Speichers 2 inkrementiert und der Speicherinhalt $m\_temp(s,z)$ der Speicherzelle in der Spalte s und in der Zeile $z_{end}(\beta)$ des zweiten Speichers 2 für alle Lx Spalten und alle Ly Zeilen des zweiten Speichers dekrementiert.

$$m\_temp(s,z) = m\_temp(s,z) + \delta_0(z - z_{start}(\beta)) - \delta_0(z - z_{end}(\beta) - 1)$$
$$\text{für alle } 1 \leq z \leq Ly \text{ und alle } 1 \leq s \leq Lx \quad (4)$$

Anschließend sind erfindungsgemäß für jede Speicherzelle in der Spalte s des ersten Speichers die in den Speicherzellen in den jeweils niedrigeren Zeilen und in der Spalte s des ersten Speichers 1 aufaddierten "1"- und "-1"-Werte - entsprechen den Inkrementen bzw. Dekrementen der in den Speicherzellen des ersten Speichers 1 durchzuführenden Inkrementierungen bzw. Dekrementierungen -addiert. Hierzu werden für jede Speicherzelle in einer Zeile der Spalte s des ersten Speichers 1 die für die jeweilige Speicherzelle aufaddierten "1"- und "-1"-Werte zu den in den Speicherzellen in allen jeweils niedrigeren Zeilen der Spalte s des ersten Speichers 1 aufaddierten "1"- und "-1"-Werten dazuaddiert, was einer rekursiven Addition entspricht.
Es wird also beginnend in der Speicherzelle in der ersten Zeile und in der Spalte s rekursiv gemäß Gleichung (5) der bis zum Ende des jeweiligen Beobachtungsintervalls in der Speicherzelle in der nächst niedrigeren Zeile und in der Spalte s des ersten Speichers 1 aufaddierte Zählerstand *m_NofTreffer(s,z-1)* - entsprechend der Häufigkeit des Auftretens von Pegelwerten des gemessenen Signals im jeweiligen Pegelbereich und zum jeweiligen Wert des Zeit- oder Frequenzrasters bis zum Ende des jeweiligen Beobachtungsintervalls - zum bis zum Ende des jeweiligen Beobachtungsintervalls in der Speicherzelle in der Zeile z und in der Spalte s des zweiten Speichers 2 aufaddierten Anzahl *m_temp(s,z)* von "1"- und "-1"-Werten - entsprechend der bis zum Ende des jeweiligen Beobachtungsintervalls ermittelten und durchzuführenden Inkrementierungen bzw. Dekrementierungen zur Aktualisierung des Zählerstands *m_NofTreffer (s,z)* in der jeweiligen Speicherzelle des ersten Speichers - für alle *Lx* Spalten und alle *Ly* Zeilen des ersten Speichers 1 addiert.

$$m\_NofTreffer(s,z) = m\_NofTreffer(s,z-1) + m\_temp(s,z)$$

$$\text{für alle } 1 \leq z \leq Ly \text{ und alle } 1 \leq s \leq Lx \qquad (5)$$

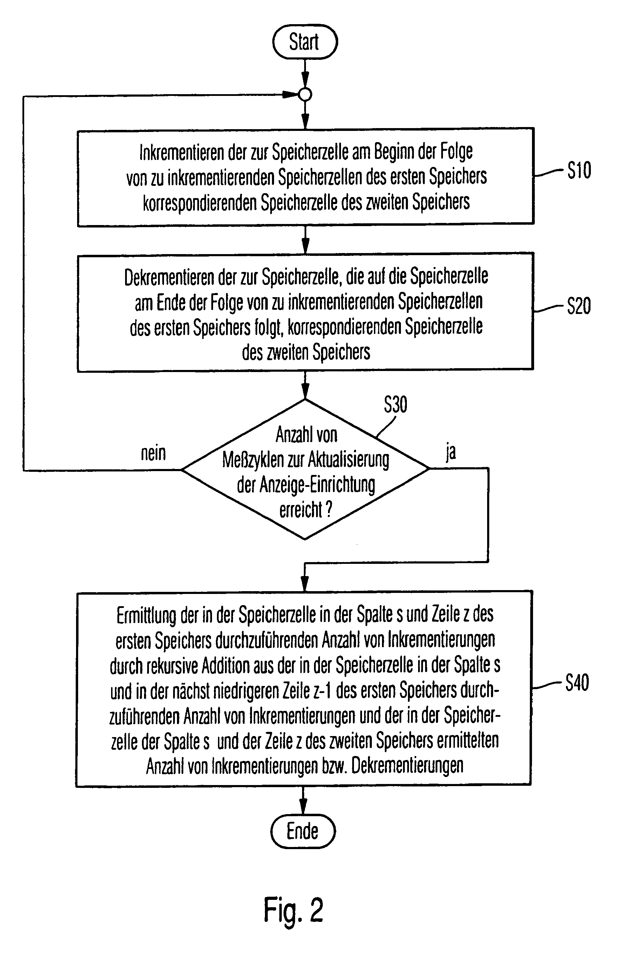

Ausgehend von den mathematischen Gleichungen (1) bis (5) ergibt sich das in Fig. 2 dargestellte erfindungsgemäße Verfahren zur Inkrementierung von in Speicherzellen eine Speichers gespeicherten Zählerständen.

Im ersten Verfahrenschritt S10 wird ausgehend von dem in einer Vorverarbeitungseinheit des Messgeräts bzw. -systems aus dem abgetasteten Messsignal bei einem bestimmten Zeit- und/oder Frequenzwert ermittelten Pegelwert und dessen Zuordnung zu einem bestimmten Pegelbereich das zum jeweiligen Pegelbereich und zum jeweiligen Wert des Zeit- und/oder Frequenzrasters gehörige Pixel der Anzeige-Einrichtung und die zugehörige Speicherzelle in einem der Anzeige-Einrichtung vorgelagerten ersten Speicher 1 ermittelt. Werden hierbei insbesondere mehrere in einer Zeile oder Spalte benachbarte Speicherzellen des ersten Speichers 1 ermittelt. So wird der Speicherinhalt *m_temp(s,z)* derjenigen Speicherzelle eines zweiten Speichers 2 gemäß Gleichung (4) um den Wert "1" inkrementiert, die zu der am Beginn der Folge von ermittelten Speicherzellen des ersten Speichers positionierten Speicherzelle korrespondiert.

Als Beginn der Folge von benachbarten Speicherzellen des ersten Speichers 1 wird in der folgenden Ausführung das linksseitige Ende der in einer Zeile benachbarten Speicherzellen bzw. das untere Ende der in einer Spalte benachbarten Speicherzellen betrachtet. Alternativ kann jedoch auch das rechtsseitige Ende der in einer Zeile benachbarten Speicherzellen bzw. das obere Ende der in einer Spalte benachbarten Speicherzellen betrachtet werden und ist von der Erfindung abgedeckt. In diesem Betrachtungsfall ist die rekursive Addition bzw. die Faltung/Summation in der Speicherzelle in der höchsten Zeile der Spalte s bzw. in der höchsten Spalte der Zeile z des ersten bzw. zweiten Speichers zu beginnen. In den Gleichungen (1) bis (5) ist folglich für diesen Betrachtungsfall der Wert "-1" durch den Wert "+1" zu ersetzen.

Im nächsten Verfahrenschritt S20 wird in analoger Vorgehensweise zum ersten Verfahrenschritt S10 der Speicherinhalt *m_temp(s,z)* derjenigen Speicherzelle des zweiten Speichers 2 gemäß Gleichung (4) um den Wert "1" dekrementiert, der zu derjenigen Speicherzelle des ersten Speichers 1 korrespondiert, die auf die am Ende der Folge von im ersten Speicher zu inkrementierenden Speicherzellen unmittelbar folgt.

Im darauf folgenden Verfahrensschritt S30 wird ermittelt, ob die Anzahl der bereits durchgeführten Mess-Zyklen der für eine erneuerte Aktualisierung der Anzeige-Einrichtung erforderlichen Anzahl von Mess-Zyklen entspricht. Ist dies nicht der Fall, so werden in einem weiteren Mess-Zyklus die im ersten Speicher 1 jeweils zu inkrementierenden Speicherzellen ermittelt und mit erneuter Aufnahme des ersten Verfahrensschritt S10 die zur Speicherzelle am Beginn einer Folge von zu inkrementierenden Speicherzellen des ersten Speichers 1 korrespondierenden Speicherzelle des zweiten Speichers 2 um den Wert "1" inkrementiert.

Ist dagegen die für eine Aktualisierung der Anzeige-Einrichtung erforderliche Anzahl von Mess-Zyklen durchgeführt worden, so wird im nächsten und abschließenden Verfahrensschritt S40 die Anzahl *m_NofTreffer(s,z)* von Inkrementierungen der Speicherzelle in der Spalte s und in der Zeile z des ersten Speichers 1 durch rekursive Addition der Anzahl *m_NofTreffer(s,z-1)* von Inkrementierungen der Speicherzelle in der Spalte s und in der nächst niedrigeren Zeile z-1 des ersten Speichers 1 und der jeweils zueinander addierten Inkrementierungen bzw. zueinander subtrahierten Dekrementierungen *m_temp(s,z)* in der Speicherzelle in der Spalte s und in der Zeile z des zweiten Speichers 2 gemäß Gleichung (5) ermittelt.

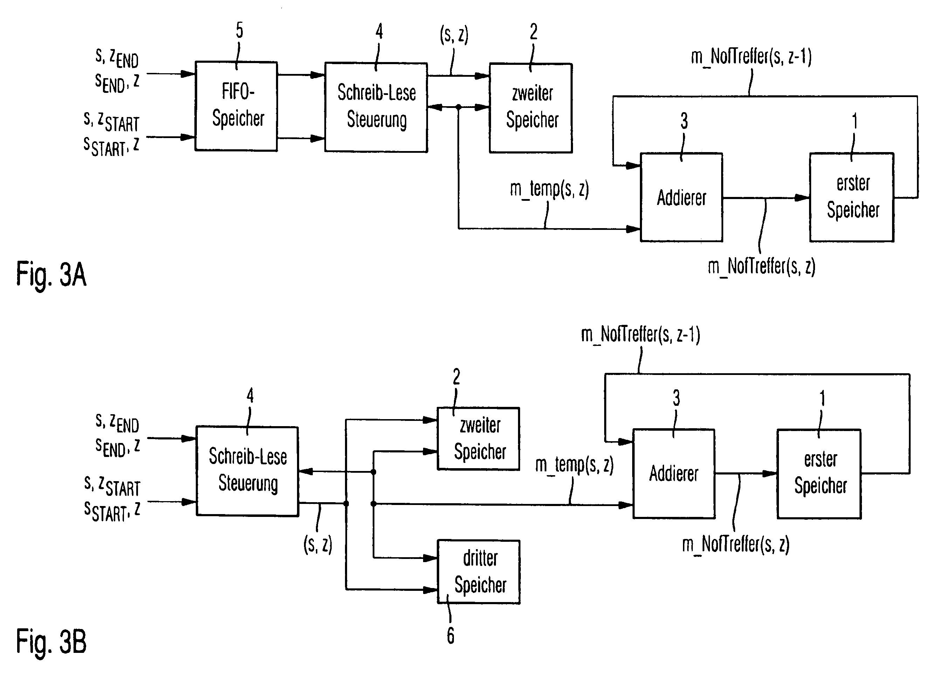

Die erste Ausführungsform der erfindungsgemäßen Vorrichtung zur Inkrementierung von in Speicherzellen eines Speichers gespeicherten Zählerständen in Fig. 3A besteht aus dem ersten Speicher 1, in dessen Speicherzellen die Häufigkeiten der zu den einzelnen Pegelbereichen und zu den einzelnen Werten des Zeit- oder Frequenzrasters in den einzelnen Mess-Zyklen jeweils gemessenen Pegelwerten abgespeichert sind.

Dem ersten Speicher 1 ist eine Addierer 3 vorgelagert, der im Fall von innerhalb des letzten Zeitintervalls von mehreren Mess-Zyklen für eine Speicherzelle des ersten Speichers 1 ermittelten Inkrementierungen bzw. Dekrementierungen die Anzahl der ermittelten Inkrementierungen bzw. Dekrementierungen, die in der zur Speicherzelle des ersten Speichers 1 korrespondierenden Speicherzelle des zweiten Speichers 2 abgespeichert sind, zum Speicherinhalt der Speicherzelle des ersten Speichers 1 mit dem darin abgespeicherten Häufigkeitswert addiert.

Dem zweiten Speicher 2 ist eine Schreib-Lese-Steuerung 4 vorgeschaltet, die im Fall einer in einem Mess-Zyklus in einer bestimmten Speicherzelle des ersten Speichers 1 durchzuführenden Inkrementierung die korrespondierenden Speicherzelle des zweiten Speichers 2 mit dem Wert "1" beschreibt und nach einer bestimmten Anzahl von Mess-Zyklen, wenn die Anzeige-Einrichtung mit den Speicherinhalten des ersten Speichers 1 beschrieben wird, alle Speicherzellen des zweiten Speichers 2 mit dem Wert "0" neu initialisiert bzw. zurücksetzt.

Um einen Datenstau am Eingang des zweiten Speichers 2 aufgrund unterschiedlicher Operationszeiten im zweiten Speicher 2 - Initialisierung aller Speicherzellen ist zeitaufwändiger als Beschreibung einzelner Speicherzellen mit Inkrementen bzw. Dekrementen - zu vermeiden, ist der Schreib-Lese-Steuerung 4 im Ausführungsbeispiel ein FIFO (first-in-first-out)-Speicher 5 vorgeschaltet, d. h. ein Speicher 5, bei dem das zuerst eingeschriebenen Element auch zuerst ausgelesen wird.

In einer zweiten Ausführungsform der erfindungsgemäßen Vorrichtung zur Inkrementierung von in Speicher-zellen eines Speichers gespeicherten Zählerständen in Fig. 3B wird anstelle des FIFO-Speicher 5 ein dritter Speicher 6 verwendet, der zum zweiten Speicher 2 parallel geschaltet ist und von der identischen Schreib-Lese-Steuerung 4 angesteuert wird. Hierbei wird im zyklischen Wechsel einer der beiden Speicher - zweiter Speicher 2 oder dritter Speicher 6 - mit Inkrementen bzw. Dekrementen über mehrere Mess-Zyklen beschrieben, während der jeweils andere der beiden Speicher neu initialisiert wird. Auf diese Weise wird die vergleichsweise zeitaufwändige Initialisierung des zweiten oder dritten Speichers 2 oder 6 mit der nicht wesentlich schneller ablaufenden Beschreibung des zweiten oder dritten Speichers 2 oder 6 mit Inkrementen über mehrere Mess-Zyklen parallelisiert.

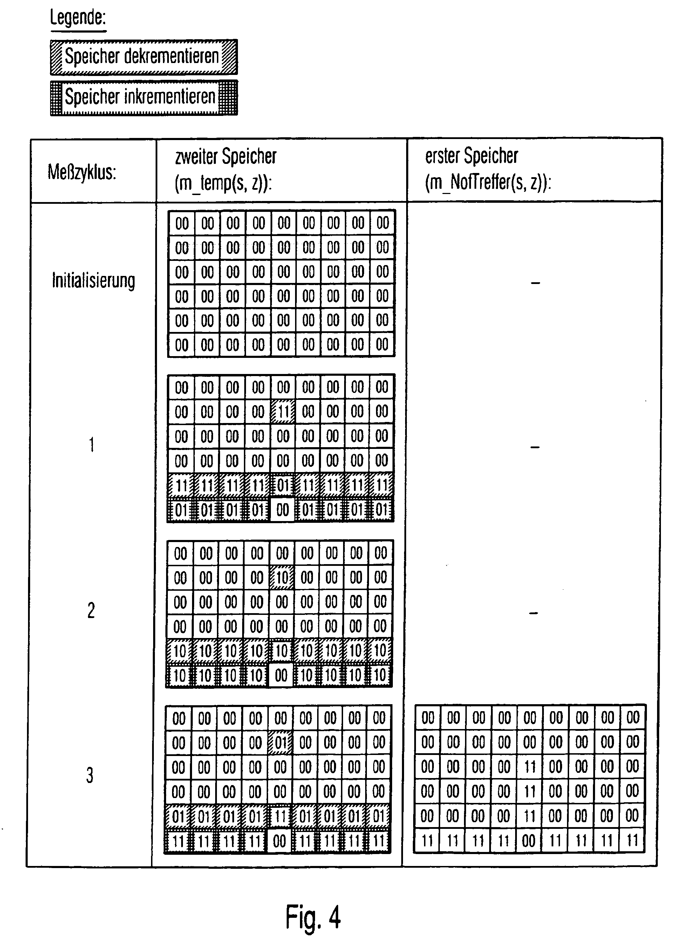

In Fig. 4 ist eine beispielhafte Speicherbelegung des ersten Speichers 1 und des zweiten Speichers 2 über insgesamt drei Mess-Zyklen dargestellt, wobei aus Anschaulichkeitsgründen in allen drei Mess-Zyklen jeweils dieselben Speicherzellen des zweiten Speichers 2 mit Inkrementen bzw. mit Dekrementen beschrieben werden. Man erkennt das Aufaddieren der einzelnen Inkremente bzw. Dekremente im zweiten Speicher 2 über die einzelnen Mess-Zyklen und die Zählerstände der korrespondierenden Speicherzellen des ersten Speichers 1 am Ende des dritten Messzykluses, die die Häufigkeitsverteilung des Messsignals über die einzelnen Pegelbereiche und die einzelnen Werte des Zeit- oder Frequenzrasters innerhalb eines Messintervalls bestehend aus drei Mess-Zyklen zwischen zwei Aktualisierungen der Anzeige-Einrichtung darstellen.

Die Erfindung ist nicht auf die dargestellten Ausführungsformen beschränkt. Von der Erfindung ist insbesondere auch die gleichzeitige Inkrementierung einer Folge von in einer Zeile und gleichzeitig in einer Spalte des Speichers angeordneten Speicherzellen abgedeckt.


**Patentansprüche**

1. Verfahren zur Inkrementierung von in Speicherzellen gespeicherten Zählerständen, wobei die Speicherzellen in Zeilen und Spalten eines ersten Speichers (1) jeweils angeordnet sind,
**dadurch gekennzeichnet,**
**dass** folgende Verfahrensschritte durchgeführt werden:

- Addieren einer Konstanten m zum in einer Speicherzelle eines zweiten Speichers (2) abgespeicherten Inhalt, die der Speicherzelle an einem Beginn einer Folge von in einer Zeile oder Spalte des ersten Speichers (2) zu inkrementierender Speicherzellen entspricht, bei jeder Inkrementierung einer Folge von Speicherzellen des ersten Speichers (1) ,
- Addieren einer Konstanten -m zum in einer Speicherzelle des zweiten Speichers (2) abgespeicherten Inhalt, die der der Speicherzelle am zum Beginn der Folge gehörigen Ende der Folge von zu inkrementierender Speicherzellen unmittelbar folgenden Speicherzelle entspricht, bei jeder Inkrementierung einer Folge von Speicherzellen des ersten Speichers (1),
- abschließendes rekursives Addieren des in einer Speicherzelle abgespeicherten Inhalts, die in einer Zeile oder Spalte des zweiten Speichers (2) angeordnet ist, zum Inhalt einer Speicherzelle, die in der nächst niedrigeren Zeile oder Spalte des ersten Speichers (1) angeordnet ist, und Speichern des Ergebnisses der Addition in der in der Zeile oder Spalte des ersten Speichers (1) angeordneten Speicherzelle.

2. Verfahren nach Anspruch 1,
**dadurch gekennzeichnet,**
**dass** +m = +1 und -m = -1 gilt.

3. Verfahren zur Inkrementierung nach Anspruch 1,
**dadurch gekennzeichnet,**

**dass** die Addition der Speicherzellen des zweiten Speichers (2) mit +1 bzw. -1 bei einer Folge von in einer Zeile des ersten Speichers (1) zu inkrementierender Speicherzellen nach folgender Formel durchgeführt wird:

$$m\_temp(s,z) = m\_temp(s,z) + \delta_0(z - z_{start}) - \delta_0(z - (z_{end} + 1)) \quad \text{für alle}$$

$$1 \leq z \leq Ly$$

und die Addition der beiden Speicherzellen des zweiten Speichers (2) bei einer Folge von in einer Spalte des ersten Speichers (1) zu inkrementierender Speicherzellen nach folgender Formel durchgeführt wird:

$$m\_temp(s,z) = m\_temp(s,z) + \delta_0(s - s_{start}) - \delta_0(s - (s_{end} + 1)) \quad \text{für alle}$$

$$1 \leq s \leq Lx$$

wobei

$s$ der Spaltenindex der Speicherzellen des ersten bzw. zweiten Speichers (1) bzw. (2),

$z$ der Zeilenindex der Speicherzellen des ersten bzw. zweiten Speichers (1) bzw. (2),

$m\_temp(s,z)$ der in der Speicherzelle in der s-ten Spalte und in der $z$-ten Zeile des zweiten Speichers (2) abgespeicherte Inhalt,

$z_{start}$ der Zeilenindex des Beginns der in einer Spalte des ersten Speichers (1) angeordneten Folge von zu inkrementierender Speicherzellen,

$Z_{end}$ der Zeilenindex des Endes der in einer Spalte des ersten Speichers (1) angeordneten Folge von zu inkrementierender Speicherzellen,

$s_{start}$ der Spaltenindex des Beginns der in einer Zeile des ersten Speichers (1) angeordneten Folge von zu inkrementierender Speicherzellen,

$S_{end}$ der Spaltenindex des Endes der in einer eine Zeile des ersten Speichers (1) angeordneten Folge von zu inkrementierender Speicherzellen,

$Ly$ die Anzahl der Zeilen des ersten bzw. zweiten Speichers (1) bzw. (2),

$Lx$ die Anzahl der Spalten des ersten bzw. zweiten Speichers (1) bzw. (2) und

$\delta_0(.)$ die Dirac-Funktion

bedeuten.

4. Verfahren zur Inkrementierung nach Anspruch 3,
**dadurch gekennzeichnet,**
**dass** die rekursive Addition des in einer Speicherzelle abgespeicherten Inhalts, die in einer Zeile des zweiten Speichers (2) angeordnet ist, zum Inhalt der in der nächst niedrigeren Zeile des ersten Speichers (1) angeordneten Speicherzelle und das Speichern des Ergebnisses der Addition in der in der Zeile des ersten Speichers (1) angeordneten Speicherzelle entsprechend der Formel

$$m\_NofTreffer(s,z) = m\_NofTreffer(s,z-1) + m\_temp(s,z) \quad \text{für alle} \ 1 \leq z \leq Ly$$

$$\text{und alle} \ 1 \leq s \leq Lx$$

und die rekursive Addition des in einer Speicherzelle abgespeicherten Inhalts die in einer Spalte des zweiten Speichers (2) angeordnet ist, zum Inhalt der in der nächst niedrigeren Spalte des ersten Speichers (1) angeordneten Speicherzelle und das Speichern des Ergebnisses der Addition in der in der Spalte des ersten Speichers (1) angeordneten Speicherzelle entsprechend der Formel

$$m\_NofTreffer(s,z) = m\_NofTreffer(s-1,z) + m\_temp(s,z) \text{ für alle } 1 \le s \le Lx$$

$$\text{und alle } 1 \le z \le Ly$$

erfolgt,
wobei

$m\_NofTreffer(s,z)$ der in der Speicherzelle in der s-ten Spalte und in der $z$-ten Zeile des ersten Speichers (1) abgespeicherte Inhalt

bedeutet.

5. Verfahren zur Inkrementierung nach einem der Ansprüche 1 bis 4,
**dadurch gekennzeichnet,**
**dass** nach der rekursiven Addition die Speicherzellen des zweiten Speichers (2) zurückgesetzt werden.

6. Vorrichtung zur Inkrementierung von Zählerständen in Speicherzellen, die in einer Zeile oder Spalte eines ersten Speichers (1) angeordnet sind, mit einem ersten Speicher (1) und einem zweiten Speicher (2),
**dadurch gekennzeichnet,**
**dass** im ersten Speicher (1) Zählerstände abgespeichert sind und der zweite Speicher (2) Speicherzellen enthält, die zu den Speicherzellen des ersten Speichers (1) korrespondieren und in denen jeweils die Differenz zwischen der Anzahl von in der jeweiligen Speicherzelle durchzuführenden Inkrementierungen gegenüber der Anzahl von in der in der nächst niedrigeren Zeile oder Spalte angeordneten Speicherzelle durchzuführenden Inkrementierungen abgespeichert ist, und
**dass** zusätzlich zwischen ersten Speicher (1) und zweiten Speicher (2) ein Addierer (3) zur rekursiven Addition des in der jeweiligen Speicherzelle des zweiten Speichers (2) abgespeicherten Inhalts zum Inhalt der in der nächst niedrigeren Zeile oder Spalte des ersten Speichers (1) jeweils angeordneten Speicherzelle und zum Speichern des Ergebnisses der Addition in der jeweiligen Speicherzelle des ersten Speichers (1) geschaltet ist.

7. Vorrichtung zur Inkrementierung von Zählerständen nach Anspruch 6,
**dadurch gekennzeichnet,**
**dass** dem zweiten Speicher (2) ein First-in-first-out-Speicher (5) zur Zwischenspeicherung der in den Speicherzellen des ersten Speichers (1) jeweils durchzuführenden Inkrementierungen vorgeschaltet ist.

8. Vorrichtung zur Inkrementierung von Zählerständen nach Anspruch 6,
**dadurch gekennzeichnet,**
**dass** zur abwechselnden Speicherung der in den Speicherzellen des ersten Speichers (1) jeweils durchzuführenden Inkrementierungen dem zweiten Speicher (2) ein dritter Speicher (6) parallel geschaltet ist.

9. Vorrichtung zur Inkrementierung von Zählerständen nach Anspruch 7 oder 8,
**dadurch gekennzeichnet,**
**dass** zusätzlich eine Schreib-Lese-Steuerung (4) zur Steuerung des Abspeicherns und des Auslesens der in den Speicherzellen des ersten Speichers (1) jeweils durchzuführenden Inkrementierungen und des Rücksetzens im zweiten Speicher (2) und/oder dritten Speicher (6) vorgesehen ist.

## Claims

1. Method for the incrementation of counter statuses in memory cells, wherein the memory cells are each arranged in rows and columns of a first memory (1),
**characterised in that**
the following procedural stages are implemented:

  - addition of a constant m to the memory content of a memory cell of a second memory (2), which corresponds to the memory cell at a beginning of a sequence of memory cells to be incremented within a row or column of the first memory (1), with every incrementation of a sequence of memory cells of the first memory (1) ;

- addition of a constant -m to the memory content of a memory cell of the second memory (2), which corresponds to the memory cell immediately following the memory cell at the end of the sequence of memory cells to be incremented associated with the beginning of the sequence, with every incrementation of a sequence of memory cells of the first memory (1) ;
- final recursive addition of the memory content of a memory cell arranged within a row or column of the second memory (2) to the memory content of the memory cell arranged in the next lower row or column of the first memory (1) and storage of the result of the addition in the memory cell arranged in the row or column of the first memory (1).

2. Method according to claim 1,
**characterised in that**
+m = +1 and -m = -1.

3. Method for incrementation according to claim 1,
**characterised in that**
the addition of the memory cells of the second memory (2) with +1 or respectively -1 in the case of a sequence of memory cells to be incremented within a row of the first memory (1) is implemented according to the following formula:

$$m\_temp(s,z) = m\_temp(s,z) + \delta_0(z - z_{start}) - \delta_0(z - (z_{end} + 1)) \quad \texttt{for all}$$

$$1 \leq z \leq Ly$$

and the addition of the two memory cells of the second memory (2) in the case of a sequence of memory cells to be incremented within a column of the first memory (1) is implemented according to the following formula:

$$m\_temp(s,z) = m\_temp(s,z) + \delta_0(s - s_{start}) - \delta_0(s - (s_{end} + 1)) \quad \texttt{for all}$$

$$1 \leq s \leq Lx$$

wherein

$s$ denotes the column index of the memory cells of the first and respectively second memory (1) or (2),
$z$ denotes the row index of the memory cells of the first and respectively second memory (1) or (2),
$m\_temp(s,z)$ denotes the memory content of the memory cell in the s-th column and in the z-th row of the second memory (2),
$z_{start}$ denotes the row index at the start of the sequence of memory cells to be incremented arranged in a column of the first memory (1),
$z_{end}$ denotes the row index at the end of the sequence of memory cells to be incremented arranged within a column of the first memory (1),
$s_{start}$ denotes the column index of the start of the sequence of memory cells to be incremented arranged within a row of the first memory (1),
$s_{end}$ denotes the column index at the end of the sequence of memory cells to be incremented arranged within a row of the first memory (1),
$Ly$ denotes the number of lines in the first and respectively second memory (1) or (2),
$Lx$ denotes the number of columns in the first and respectively second memory (1) or (2), and
$\delta_0(.)$ denotes the Dirac function.

4. Method for incrementation according to claim 3,
**characterised in that**
the recursive addition of the memory content of a memory cell arranged in a row of the second memory (2) to the content of the memory cell arranged in the next lower row of the first memory (1) and the storage of the result of the addition in the memory cell arranged within the row of the first memory (1) is implemented according to the formula:

$$m\_NofTreffer(s,z) = m\_NofTreffer(s,z-1) + m\_temp(s,z) \texttt{ for all}$$

$$1 \le z \le Ly \texttt{ and all } 1 \le s \le Lx$$

and the recursive addition of the memory content of a memory cell arranged in a column of the second memory (2) to the content of the memory cell arranged in the next lower column of the first memory (1) and the storage of the result of the addition in the memory cell arranged within the column of the first memory (1) is implemented according to the following formula:

$$m\_NofTreffer(s,z) = m\_NofTreffer(s-1,z) + m\_temp(s,z) \texttt{ for all}$$

$$1 \le s \le Lx \texttt{ and all } 1 \le z \le Ly$$

wherein

$m\_NofTreffer(s,z)$ denotes the memory content of the memory cell in the s-th column and in the z-th row of the first memory (1) .

5. Method for incrementation according to any one of claims 1 to 4,
**characterised in that**
the memory cells of the second memory (2) are reset after the recursive addition.

6. Device for the incrementation of counter statuses in memory cells, which are arranged within a row or column of a first memory (1), with a first memory (1) and a second memory (2),
**characterised in that**
counter statuses are stored in the first memory (1), and the second memory (2) contains memory cells which correspond to the memory cells of the first memory (1) and in which the difference between the number of incrementations to be implemented in the respective memory cell and the number of incrementations to be implemented in the memory cell arranged in the next lower row or column is stored respectively, and
additionally, between the first memory (1) and the second memory (2), an adder (3) is connected for the recursive addition of the memory content of the respective memory cell of the second memory (2) to the content of the memory cell arranged respectively in the next lower row or column of the first memory (1) and for the storage of the result of the addition in the respective memory cell of the first memory (1) .

7. Device for the incrementation of counter statuses according to claim 6,
**characterised in that**
a first-in-first-out memory (5) for buffering the incrementations to be implemented respectively in the memory cells of the first memory (1) is connected upstream of the second memory (2).

8. Device for the incrementation of counter statuses according to claim 6,
**characterised in that**
a third memory (6) is connected in parallel to the second memory (2) for the alternating storage of the incrementations to be implemented respectively in the memory cells of the first memory (1).

9. Device for the incrementation of counter statuses according to claim 7 or 8,
**characterised in that**
a read/write control unit (4) for controlling the storage and readout of the incrementations and for the resetting to be implemented respectively in the memory cells of the first memory (1) is provided additionally in the second memory (2) and/or in the third memory (6) .

**Revendications**

1. Procédé pour l'incrémentation de positions de compteur, stockées dans les cellules de mémoire, lesdites cellules de mémoire étant agencées respectivement en lignes et colonnes dans une première mémoire (1),
**caractérisé en ce que** les étapes suivantes du procédé sont mises en oeuvre :

- addition d'une constante m au contenu stocké dans une cellule de mémoire d'une deuxième mémoire (2), laquelle correspond à la cellule de mémoire au début d'une succession de cellules de mémoire à incrémenter dans une ligne ou colonne de la première mémoire (1), à chaque incrémentation d'une succession de cellules de mémoire de la première mémoire (1),
- addition d'une constante -m au contenu stocké dans une cellule de mémoire de la deuxième mémoire (2), laquelle correspond à la cellule de mémoire directement consécutive à la cellule de mémoire à la fin de la succession de cellules de mémoire à incrémenter, appartenant au début de la succession, à chaque incrémentation d'une succession de cellules de mémoire de la première mémoire (1),
- addition récursive finale du contenu stocké dans une cellule de mémoire, qui est agencée dans une ligne ou colonne de la deuxième mémoire (2), au contenu d'une cellule de mémoire qui est agencée dans la ligne ou colonne de rang directement inférieur de la première mémoire (1), et stockage du résultat de l'addition dans la cellule de mémoire agencée dans la ligne ou colonne de la première mémoire (1).

2. Procédé selon la revendication 1, **caractérisé en ce qu'**on applique +m = +1 et -m = -1.

3. Procédé d'incrémentation selon la revendication 1, **caractérisé en ce que** l'addition des cellules de mémoire de la deuxième mémoire (2) avec +1 et -1, dans le cas d'une succession de cellules de mémoire à incrémenter dans une ligne de la première mémoire (1), est effectuée selon la formule suivante :

$$m\_temp(s,z) = m\_temp(s,z) + \delta_0(z - z_{start}) - \delta_0(z - (z_{end} + 1))$$

pour tous les $1 \leq z$ $Ly$

et l'addition des deux cellules de mémoire de la deuxième mémoire (2), dans le cas d'une succession de cellules de mémoire à incrémenter dans une colonne de la première mémoire (1), est effectuée selon la formule suivante :

$$m\_temp(s,z) = m\_temp(s,z) + \delta_0(s - s_{start}) - \delta_0(s - (s_{end} + 1))$$

pour tous les $1 \leq s \leq Lx$

dans lesquelles

$s$ est l'index de colonne des cellules de mémoire de la première mémoire (1) et de la deuxième mémoire (2),
$z$ est l'index de ligne des cellules de mémoire de la première mémoire (1) et de la deuxième mémoire (2),
$m\_temp(s,z)$ est le contenu stocké dans la cellule de mémoire dans la $s$ème colonne et dans $z$ème ligne de la deuxième mémoire (2),
$z_{start}$ est l'index de ligne du début de la succession de cellules de mémoire à incrémenter, agencée dans une colonne de la première mémoire (1),
$z_{end}$ est l'index de ligne de la fin de la succession de cellules de mémoire à incrémenter, agencée dans une colonne de la première mémoire (1),
$s_{start}$ est l'index de colonne du début de la succession de cellules de mémoire à incrémenter, agencée dans une ligne de la première mémoire (1),
$s_{end}$ est l'index de colonne de la fin de la succession de cellules de mémoire à incrémenter, agencée dans une ligne de la première mémoire (1),
$Ly$ est le nombre de lignes de la première ou de la deuxième mémoire (1) ou (2),
$Lx$ est le nombre de colonnes de la première ou de la deuxième mémoire (1) ou (2),
$\delta_0(.)$ est la fonction de Dirac.

4. Procédé d'incrémentation selon la revendication 3, **caractérisé en ce que** l'addition récursive du contenu stocké dans une cellule de mémoire, qui est agencée dans une ligne de la deuxième mémoire (2), au contenu de la cellule de mémoire agencée dans la ligne de rang directement inférieur de la première mémoire (1), et le stockage du résultat de l'addition dans la cellule de mémoire, agencée dans la ligne de la première mémoire (1), sont effectués conformément à la formule :

$$m\_NofTreffer(s,z) = m\_NofTreffer(s,z-1) + m\_temp(s,z) \text{ pour}$$

$$\text{tous les } 1 \leq z \ Ly \text{ et tous les } 1 \leq s \ Lx$$

et l'addition récursive du contenu stocké dans une cellule de mémoire, qui est agencée dans une colonne de la deuxième mémoire (2), au contenu de la cellule de mémoire agencée dans la colonne de rang directement inférieur de la première mémoire (1), et le stockage du résultat de l'addition dans la cellule de mémoire agencée dans la colonne de la première mémoire (1) sont effectués conformément à la formule

$$m\_NofTreffer(s,z) = m\_NofTreffer(s-1,z) + m\_temp(s,z) \text{ pour}$$

$$\text{tous les } 1 \leq s \ Lx \text{ et tous les } 1 \leq z \ Ly,$$

dans lesquelles

$m\_NofTreffer(s,z)$ est le contenu stocké dans la cellule de mémoire dans la $s^{\text{ème}}$ colonne et dans $z^{\text{ème}}$ ligne de la première mémoire (1).

**5.** Procédé d'incrémentation selon l'une quelconque des revendications 1 à 4, **caractérisé en ce que** les cellules de mémoire de la deuxième mémoire (2) sont remises à zéro après l'addition récursive.

**6.** Dispositif pour l'incrémentation de positions de compteur dans des cellules de mémoire, qui sont agencées dans une ligne ou colonne d'une première mémoire (1), comportant une première mémoire (1) et une deuxième mémoire (2),
**caractérisé en ce que** des positions de compteur sont stockées dans la première mémoire (1), et la deuxième mémoire (2) contient des cellules de mémoire, qui correspondent aux cellules de mémoire de la première mémoire (1) et dans lesquelles est stockée respectivement la différence entre le nombre d'incrémentations à effectuer dans la cellule de mémoire respective et le nombre d'incrémentations à effectuer dans la cellule de mémoire agencée dans la ligne ou colonne de rang directement inférieur, et
**en ce que**, en plus, entre la première mémoire (1) et la deuxième mémoire (2) est monté un additionneur (3) pour l'addition récursive du contenu, stocké dans la cellule de mémoire respective de la deuxième mémoire (2), au contenu de la cellule de mémoire agencée dans la ligne ou colonne de rang directement inférieur de la première mémoire (1), et pour le stockage du résultat de l'addition dans la cellule de mémoire respective de la première mémoire (1).

**7.** Dispositif pour l'incrémentation de positions de compteur selon la revendication 6, **caractérisé en ce qu'**en amont de la deuxième mémoire (2) est montée une mémoire (5) du type premier entré - premier sorti, destinée au stockage temporaire des incrémentations à effectuer respectivement dans les cellules de mémoire de la première mémoire (1).

**8.** Dispositif pour l'incrémentation de positions de compteur selon la revendication 6, **caractérisé en ce que** pour le stockage alterné des incrémentations à effectuer respectivement dans les cellules de mémoire de la première mémoire (1), une troisième mémoire (6) est montée en parallèle à la deuxième mémoire (2).

**9.** Dispositif pour l'incrémentation de positions de compteur selon la revendication 7 ou 8, **caractérisé en ce qu'**il est prévu, en plus, un dispositif de commande d'enregistrement et lecture (4) destiné à commander l'enregistrement et la lecture des incrémentations à effectuer respectivement dans les cellules de mémoire de la première mémoire (1), et la remise à zéro dans la deuxième mémoire (2) ou la troisième mémoire (6).

Fig. 1

**Fig. 2**

Fig. 3A

Fig. 3B

Legende:

| Speicher dekrementieren |

| Speicher inkrementieren |

| Meßzyklus: | zweiter Speicher (m_temp(s, z)): | erster Speicher (m_NofTreffer(s, z)): |
|---|---|---|
| Initialisierung | 00 00 00 00 00 00 00 00 00<br>00 00 00 00 00 00 00 00 00<br>00 00 00 00 00 00 00 00 00<br>00 00 00 00 00 00 00 00 00<br>00 00 00 00 00 00 00 00 00<br>00 00 00 00 00 00 00 00 00 | – |
| 1 | 00 00 00 00 00 00 00 00 00<br>00 00 00 00 11 00 00 00 00<br>00 00 00 00 00 00 00 00 00<br>00 00 00 00 00 00 00 00 00<br>11 11 11 11 01 11 11 11 11<br>01 01 01 01 00 01 01 01 01 | – |
| 2 | 00 00 00 00 00 00 00 00 00<br>00 00 00 00 10 00 00 00 00<br>00 00 00 00 00 00 00 00 00<br>00 00 00 00 00 00 00 00 00<br>10 10 10 10 10 10 10 10 10<br>10 10 10 10 00 10 10 10 10 | – |
| 3 | 00 00 00 00 00 00 00 00 00<br>00 00 00 00 01 00 00 00 00<br>00 00 00 00 00 00 00 00 00<br>00 00 00 00 00 00 00 00 00<br>01 01 01 01 11 01 01 01 01<br>11 11 11 11 00 11 11 11 11 | 00 00 00 00 00 00 00 00 00<br>00 00 00 00 00 00 00 00 00<br>00 00 00 00 11 00 00 00 00<br>00 00 00 00 11 00 00 00 00<br>00 00 00 00 11 00 00 00 00<br>11 11 11 11 00 11 11 11 11 |

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20060209081 A1
- US 5818434 A